# EUROPÄISCHE PATENTSCHRIFT

(11) **EP 2 253 007 B1**
(45) Veröffentlichungstag und Bekanntmachung des Hinweises auf die Patenterteilung: **15.05.2013**
(21) Anmeldenummer: 09720887.0
(22) Anmeldetag: 05.03.2009
(51) Int. Cl.: H01J 37/244, H01J 37/256, H01J 37/28

(54) **RÖNTGENDETEKTOR MIT STREUFELDARMER MAGNETFALLE**
X-RAY DETECTORS COMPRISING LOW STRAY FIELD MAGNETIC TRAPS
DÉTECTEUR DE RAYONS X CONTENANT PIÈGE MAGNÉTIQUE PAUVRE EN CHAMP DE FUITE

(30) Priorität: 14.03.2008 DE 102008014578
(43) Veröffentlichungstag der Anmeldung: 24.11.2010
(73) Patentinhaber: Bruker Nano GmbH, 12489 Berlin (DE)
(72) Erfinder: BAUMANN, Thomas, 49159 Münster (DE)
(74) Vertreter: Gulde Hengelhaupt Ziebig & Schneider
(86) Internationale Anmeldenummer: PCT/EP2009/052583
(87) Internationale Veröffentlichungsnummer: WO 2009/112416

(56) Entgegenhaltungen:
- EP-A- 1 557 848
- DE-A1- 3 024 412
- DE-A1- 4 202 005
- JP-A- 57 128 088
- JP-A- 2000 019 133
- US-A- 3 969 629
- US-A- 5 757 018
- US-A1- 2002 100 877
- 'Halbach array', [Online] Wikipedia Gefunden im Internet: <URL:http://en.wikipedia.org/wiki/Halbach_a rray> [gefunden am 2011-03-23]
- 'Halbach array', [Online] 03 Februar 2009, Wikipedia Gefunden im Internet: <URL:http://en.wikipedia.org/w/index.php?ti tle=Halbach_array&oldid=268261381> [gefunden am 2011-07-19]

## Beschreibung

Die Erfindung betrifft einen Röntgendetektor für die Elektronenstrahlmikroanalyse, welcher eine Magnetfalle zum Einfangen von Elektronen enthält.

Die Elektronenstrahlmikroanalyse ist eine weit verbreitete Methode der Elementaranalytik. Dabei wird Röntgenstrahlung, die in einem Elektronenmikroskop, insbesondere einem Rasterelektronenmikroskop (REM), bei der Abtastung einer Probe durch einen Elektronenstrahl entsteht, detektiert und ausgewertet. Zunächst nur als Spezialanwendung in Zusammenhang mit hierfür besonders ausgelegten Geräten wie z.B. Elektronenstrahl-Mikrosonden geplant, hat sich die Elektronenstrahlmikroanalyse zwischenzeitlich zu einer in praktisch jedem REM-Labor routinemäßig angewendeten Methode entwickelt.

Der entscheidende Schritt hierfür war die Einführung von energiedispersiven Röntgendetektoren (EDX), die sich durch ihre einfache und robuste Bauweise, Wartungsarmut, stabile Arbeitsweise und nicht zuletzt dem relativ großen erfassten Raumwinkel (engl. solid angle) gegenüber den vormals ausschließlich vorhandenen wellenlängendispersiven Geräten (WDX) auszeichnen.

Mit WDX-Röntgendetektoren wird die Röntgenstrahlung Wellenlängen-abhängig analysiert. Dazu wird die Strahlung zunächst auf einen Monochromator-Einkristall (z.B. LiF, PET, TAP etc.) gestrahlt, an dem Bragg-Reflexion stattfindet. Das durch diese Reflexion entstandene monochromatische Röntgenlicht, welches der Bragg'schen Beziehung n·λ = 2·d·sinθ genügt, wird auf einen Detektor, z.B. ein Proportionalzählrohr geleitet.

EDX-Detektoren verfügen über ein Eingangsfenster, einen Halbleiterkristall, der axial in Sichtachse des Detektors auf einem sogenannten Kühlfinger angeordnet ist, und eine Verstärkereinheit, die typischerweise einen Feldeffekt-Transistor (FET) und einen Vorverstärker aufweist. Ein EDX-Detektor weist ein relativ großes, homogenes Volumen auf, das Röntgenstrahlung aus nahezu beliebiger Richtung erfassen kann. Anders als beim WDX-Detektor ist eine Fokussierung und Kollimierung der Strahlung durch Ausblenden eines nur sehr schmalen Strahlenbündels daher nicht erforderlich. Insbesondere der große Raumwinkel der von EDX-Detektoren erfassten Röntgenstrahlung, d.h. der ungleich höhere Anteil der genutzten Strahlung an der insgesamt erzeugten, gestattete es, eine Mikroanalyse an gebräuchlichen, abbildenden Elektronenmikroskopen durchzuführen, da nunmehr der Unterschied zwischen dem für die Abbildung geeigneten und dem für die Röntgenspektrometrie nötigen Strahlstrom minimiert war.

Die Entwicklung der REMs hin zu immer besserer elektronenoptischer Auflösung, die Verbesserung der Elektronendetektoren, aber auch das vermehrte Interesse an organischen oder anderweitig empfindlichen Proben, haben den üblichen Strahlstrom soweit sinken lassen, dass in vielen Fällen auch mit EDX-Detektoren deutliche Grenzen gesetzt sind. Diese können derzeit nur durch extrem lange Messzeiten kompensiert werden. Besonders deutlich wird das Problem bei sogenannten SDD-Detektoren (Siliziumdriftdetektor, silicon drift detector), die von ihrer physikalischen Wirkungsweise und Bauart her ein Vielfaches der üblichen Strahlungsmenge erfassen könnten. Bei proben- oder gerätebedingter Begrenzung des Strahlstromes ist der einzige Weg, die erfasste Strahlungsmenge zu vergrößern und damit die Messzeit zu verringern bzw. fortgeschrittene Messprinzipien zu ermöglichen, den vom Detektor erfassten Raumwinkel der Strahlung zu erhöhen. Zu diesem Zweck ist ein möglichst geringer Abstand des Detektors zu der Probe wünschenswert, was einerseits jedoch durch die Detektorgröße limitiert ist und andererseits durch bauliche Gegebenheiten des Elektronenmikroskops. In derzeitigen Geräten werden Abstände zwischen dem Detektor und der Probe im Bereich von etwa 5 bis 10 mm realisiert.

Übliche EDX-Detektoren verfügen ferner über eine Magnetfalle, um den Halbleiterkristall vor gestreuten Elektronen des Elektronenstrahls zu schützen. Herkömmliche Magnetfallen weisen einen umlaufenden Eisenring auf, in dessen inneren Umfang zwei einander gegenüberliegende Permanentmagnete mit übereinstimmender magnetischer Orientierungsrichtung angeordnet sind. Durch das zwischen den Permanentmagneten aufgebaute Magnetfeld werden die Elektronen seitlich abgelenkt und gelangen somit nicht in das Detektorelement. Die Magnetfalle, die in Sichtachse des Detektors vor dem Kristall angeordnet ist führt in nachteiliger Weise zu einer Vergrößerung des Abstandes zwischen Kristall und Probe. Problematisch bei diesen herkömmlichen Magnetfallen ist ferner ihr magnetisches Streufeld, das jenseits des äußeren Umfangs des Eisenrings austritt und zu Störungen des Elektronenstrahls beziehungsweise der Elektronenstrahloptik der Elektronenmikroskopie führt.

Aus JP 2000/019133 A ist ein Röntgendetektor mit zwei Detektorelementen und mit einer Magnetfalle zum Einfangen von Elektronen in einem Elektronenmikroskop bekannt. Die Magnetfälle weist vier Permanentmagnete auf, die paarweise einander gegenüberliegend angeordnet sind, so dass im Zentrum jeweils zweier Permanentmagnete jeweils ein gerichtetes homogenes Magnetfeld vorliegt. Die beiden Magnetfelder sind im Strahlengang jeweils eines Detektorelements angeordnet. Rückseitig an den Magnetelementen ist jeweils ein Element angeordnet, das den rückwärtigen Austritt des Magnetfeldes verhindern soll. In einer Ausführung sind diese rückseitigen Elemente als eine umlaufende rechteckige Struktur ausgebildet.

EP 1 557 848 A beschreibt eine Vorrichtung zur Erzeugung eines Magnetreldes, die beispielsweise in MRT-Geraten oder in Apparaturen zur Herstellung von Halbleiterelementen, beispielsweise in Plasmabeschichtungsgeräten eingesetzt wird. US 6, 768, 402 B2 zeigt eine ähnliche, ein sogenanntes Halback-Array enthaltende Vorrichtung. Aufgabe der vorliegenden Erfindung ist es daher, einen Röntgendetektor mit einer Magnetfalle zur Verfügung zu stellen, die ein vermindertes magnetisches Streufeld aufweist und dabei gegenüber herkömmlichen Magnetfallen keine vergrößerte Bautiefe, idealerweise sogar eine geringere Bautiefe beansprucht.

Die Aufgabe wird nach der Erfindung durch einen Röntgendetektor mit den Merkmalen des Anspruchs 1 gelöst. Der erfindungsgemäße Röntgendetektor für die Elektronenstrahlmikroanalyse umfasst:
(a) ein Detektorelement und
(b) eine in Sichtachse des Detektorelements angeordnete Magnetfalle zum Einfangen von Elektronen, umfassend
   (i) ein Ringelement aus einem weichmagnetischen Material mit einem inneren und einem äußeren Umfang sowie
   (ii) eine Anzahl N von Magnetelementen umfassend ein permanentmagnetischen Material, die an dem inneren Umfang des Ringelements aneinandergrenzend so angeordnet sind, dass sie mosaikartig einen geschlossenen Ring ergeben, und deren magnetische Orientierungsrichtung so gewählt ist, dass im Zentrum der Magnetfalle ein gerichtetes Magnetfeld vorliegt, wobei die Anzahl N der Magnetelemente mindestens drei beträgt.

Erfindungsgemäß sind die Magnetelemente entlang des inneren Umfangs des Ringelements so aneinandergrenzend angeordnet und ihre Querschnittsformen so gewählt, dass die Magnetelemente sich mosaikartig zu einem geschlossenen Ring fügen. Auf diese Weise wird das zur Verfügung stehende Volumen optimal genutzt und das Gesamtmagnetvolumen maximiert, wodurch wiederum das zentrale Magnetfeld im Bauvolumen verstärkt wird.

Durch die Anordnung von mehr als zwei Magnetelementen werden mehrere vorteilhafte, zum Teil unvorhergesehene Effekte erzielt. Zunächst einmal gelingt es, ein gegenüber den im Stand der Technik verwendeten Magnetfallen stärkeres und homogeneres Magnetfeld darzustellen, das somit effektiver Elektronen abzuschirmen vermag. Daneben erlaubt das stärkere Magnetfeld durch Verwendung eines weniger dicken Ringelements sowie dünnerer Permanentmagnete die Einbautiefe der Magnetfalle zu verringern, wodurch eine nähere Anordnung des Röntgendetektorelements an der Probe und damit die Erfassung eines größeren Raumwinkels möglich ist. Besonders überraschend war die Beobachtung, dass das magnetische Streufeld, das außen an dem Ringelement austritt, gegenüber bekannten Magnetfallen verringert ist, d.h. dass das nach außen austretende Magnetfeld effektiver in das Ringelement abgeleitet wird. Hierdurch wird die Störung des Elektronenstrahls des Elektronenmikroskops verringert.

Erfindungsgemäß ist die Anzahl N der Magnetelemente ≥ 3. Nach einer vorteilhaften Ausgestaltung der Erfindung ist die Anzahl N der Magnetelemente entsprechend 2n + 2 gewählt, wobei n eine natürliche Zahl ist. Gegenüber einer ungeraden Anzahl hat die gerade Anzahl den Vorteil, sich herstellungstechnisch einfacher realisieren zu lassen. Mit zunehmender Anzahl N kann die Homogenität des Magnetfeldes verbessert und das Streufeld vermindert werden, wobei jedoch gleichzeitig der Herstellungsaufwand steigt. In diesem Zusammenhang stellt eine Anzahl von 4, 6 oder 8 einen besonders geeigneten Kompromiss dar, wobei eine Falle mit N = 6 Magnetelementen besonders bevorzugt ist.

Das Material der Magnetelemente wird so gewählt, dass bei möglichst geringem Volumen der Magnete ein Magnetfeld mit möglichst hoher Feldstärke erzeugt wird. Dafür wird insbesondere ein permanentmagnetisches Material mit einem möglichst hohen magnetischen Energieprodukt (B×H)ₘₐₓ gewählt - vorzugsweise von mindestens 50 kJ/m³, insbesondere von mindestens 100 kJ/m³, vorzugsweise von mindestens 200 kJ/m³. Besonders geeignete Materialien umfassen z.B. Neodym-Eisen-Bor- und Samarium-Cobalt-Verbindungen ((B×H)ₘₐₓ ≈ 360 kJ/m³ bzw. 225 kJ/m³). Zudem kommen auch Kompositmaterialien in Frage, die Partikel eines permanentmagnetischen Materials umfassen, das eingebettet in einem geeigneten Kunststoff ist, z.B. in Gießharz. Es versteht sich, dass grundsätzlich auch jedes andere Material mit einem ausreichend hohen Energieprodukt (B×H)ₘₐₓ im Rahmen der vorliegenden Erfindung eingesetzt werden kann.

Bei dem Material des Ringelements kommt es in erster Linie auf seine Fähigkeit an, Magnetfelder in seinem Inneren zu verdichten, um das (äußere) Streufeld zu minimieren, d.h. das Material sollte über eine möglichst hohe magnetische Permeabilität verfügen. Hier sind Werte - für die relative Permeabilität µᵣ - von zumindest 1000, besser jedoch 10000 und höher bevorzugt. Es sind jedoch auch Materialien bekannt, die relative Permeabilitäten µᵣ von gegenwärtig bis zu ca. 350000 erreichen. Es versteht sich, dass derartige Materialien im Rahmen der Erfindung ebenfalls einsetzbar sind. Ein geeignetes Material für das Ringelement ist z.B. Eisen, das eine Permeabilität µᵣ von ca. 10000 bis 40000 besitzt.

Die Erfindung wird nachfolgend anhand von Ausführungsbeispielen und den dazugehörigen Zeichnungen näher erläutert. Es zeigen:
- Fig. 1: einen grundsätzlichen Aufbau zur Elektronenstrahlmikroanalyse mit einem REM und einem Röntgendetektor;
- Fig. 2: eine Magnetfalle gemäß Stand der Technik;
- Fig. 3: eine erfindungsgemäße Magnetfalle nach einer ersten vorteilhaften Ausgestaltung der Erfindung, und
- Fig. 4: eine erfindungsgemäße Magnetfalle nach einer zweiten vorteilhaften Ausgestaltung der Erfindung.

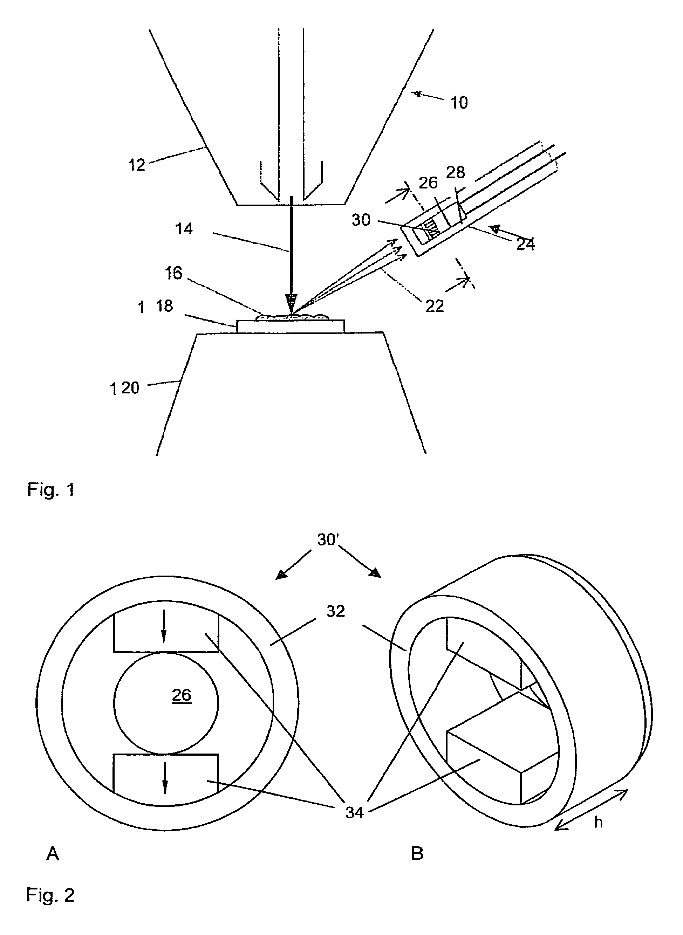

Fig. 1 zeigt eine Apparatur zur Elektronenstrahlmikroanalyse, bei der ein insgesamt mit 10 bezeichnetes REM einen Polschuh 12 aufweist, aus welchem ein Elektronenstrahl 14 austritt. Der Elektronenstrahl 14 ist auf eine Probe 16 gerichtet, die von einem Probenhalter 18 gehalten wird, welcher sich auf einem Probentisch 20 befindet. Der aus dem Polschuh 12 des Elektronenmikroskops 10 heraustretende Elektronenstrahl 14 regt die im Probenhalter 18 gehaltene Probe 16 an, infolge dessen Röntgenstrahlung 22 von der Probe 16 emittiert und nachfolgend in einem insgesamt mit 24 bezeichneten Röntgendetektor detektiert wird.

Der EDX-Röntgendetektor 24 weist als Detektorelement 26 einen Halbleiterkristall auf, dessen röntgensensitive Stirnfläche von der eintretenden Röntgenstrahlung 22 bestrahlt wird. Das Detektorelement 26 kann etwa ein Si(Li)-Detektor, ein HPGe-Detektor, eine PIN-Diode, ein aus Verbindungshalbleitern bestehender Detektor, ein SDD mit externen Transistoren oder ein Silizium-Driftdetektor mit integriertem FET (I-FET SDD) sein. Rückseitig des Detektorelements 26 weist der Detektor 24 eine Kühlvorrichtung 28 auf, die insbesondere ein Peltierelement ist.

Im Röntgenstrahlungsweg dem Detektorelement 26 vorgeschaltet, d.h. in dessen Sichtachse (Verbindungsstrecke zwischen Detektorelement 26 und Probe 16) angeordnet, weist der Röntgendetektor 24 gemäß der vorliegenden Erfindung ferner eine Magnetfalle 30 auf, deren Aufbau weiter unten näher erläutert wird. Aufgabe der Magnetfalle 30 ist es, Streuelektronen des Elektronenstrahls 14 abzuschirmen, um das Detektorelement 26 vor diesen zu schützen.

Fig. 2 zeigt eine Magnetfalle 30' gemäß dem Stand der Technik, wobei in Fig. 2A eine Ansicht gemäß der in Figur 1 angedeuteten Schnittlinie dargestellt ist und in Fig. 2B eine perspektivische Ansicht. Die herkömmliche Magnetfalle 30' umfasst ein Ringelement 32, das typischerweise aus Eisen besteht. Entlang eines inneren Umfangs des Ringelements 32 sind einander gegenüberliegend zwei Magnetelemente 34 angeordnet, deren magnetische Orientierung (in Figur 2A durch die Pfeile bei den Magnetelementen 34 angedeutet) gleichgerichtet ist. Zwischen den beiden Magneten 34 wird in der Ebene der Magnetfalle 30' und vor dem Detektorelement 26 ein Magnetfeld erzeugt wobei die (nicht dargestellten) Magnetfeldlinien sich zwischen den beiden Magneten 34 erstrecken. Aufgrund des Magnetfeldes werden eintretende Elektronen seitlich in Richtung des Ringelementes 32 abgelenkt und gelangen somit nicht zum Detektorelement 26.

Nachteilig an dem bekannten Aufbau gemäß Figur 2 ist zum einen die Notwendigkeit einer relativ großen Tiefe h (s. Fig. 2B) der Magnetfalle 30', um ein für die sichere Elektronenabschirmung ausreichend starkes Magnetfeld zu erzeugen. Die große Tiefe h der Magnetfalle 30' bedingt einen relativ großen Abstand des Detektorelements 26 von der Probe 16 und damit einen relativ geringen erfassten Raumwinkel. Ferner tritt ein relativ starkes magnetisches Streufeld aus dem äußeren Umfang des Ringelements 32 nach außen aus, insbesondere an den Positionen der Magnetelemente 34. Dieses Streufeld führt jedoch zu Störungen der elektronenmikroskopischen Messung, wodurch wiederum die Einhaltung eines Mindestabstandes zwischen Röntgendetektor 24 und Elektronenstrahl 14 erforderlich ist.

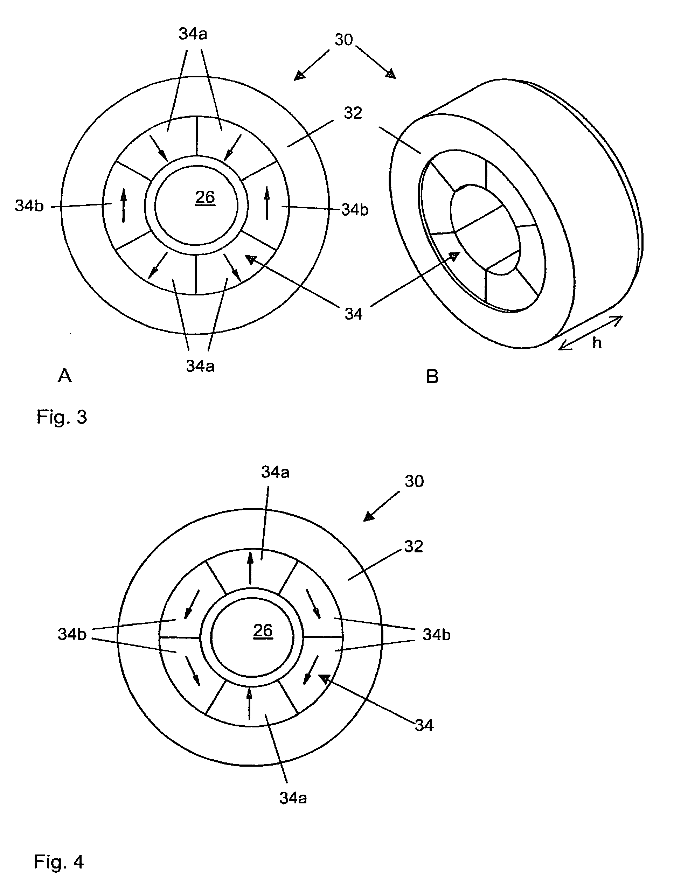

Diese Probleme werden mit einer erfindungsgemäßen Magnetfalle 30 überwunden, von welcher eine vorteilhafte Ausgestaltung in Figur 3 dargestellt ist, wobei in Fig. 3A wiederum eine Ansicht gemäß der in Figur 1 angedeuteten Schnittlinie gezeigt ist und in Fig. 3B eine perspektivische Ansicht.

Erfindungsgemäß ist eine gegenüber dem Stand der Technik größere Anzahl von mindestens drei Magnetelementen 34 entlang der inneren Umfangslinie des Ringelements 32 vorgesehen, wobei aus Symmetriegründen und zur Erzeugung eines möglichst homogenen Magnetfeldes in der Ebene der Magnetfalle 30 eine gerade Anzahl N bevorzugt ist, insbesondere N = 4, 6 oder 8. Im gezeigten Beispiel sind sechs Magnetelemente 34 in Form von Ringsegmenten vorhanden, die in vorteilhafter Weise unmittelbar aneinander angrenzend angeordnet sind und sich dabei mosaikartig zu einem Ring zusammenfügen. Andere Ausgestaltungen der Magnetelemente 34 bezüglich ihres Querschnitts in der Ebene der Magnetfalle 30 sind ebenfalls möglich, beispielsweise in Form von Ringabschnitten (bei welchen die zum Zentrum der Falle 30 gerichtete innere Kontur der Magnetelemente 34 statt der in Figur 3 gezeigten gekrümmten Form gerade verläuft). Bevorzugt sind jedoch solche Formen, deren Außenkontur der inneren Umfangslinie des Ringelements 32 entsprechen, so dass die Magnetelemente 34 lückenlos an demselben anfügen.

Durch die höhere Anzahl der Magnetelemente 34 entsteht einerseits ein gegenüber dem Stand der Technik stärkeres zentrales Magnetfeld. Dies erlaub eine Bauweise der erfindungsgemäßen Magnetfalle 30 mit einer geringeren Tiefe h (Figur 3B), so dass der kritische Abstand zwischen Detektorelement 26 und Probe 16 gegenüber herkömmlichen Systemen verringert werden kann. Ferner erlaubt das stärkere Magnetfeld der Falle 30 auch eine wirksamere Abschirmung von Elektronen. Darüber hinaus hat sich erwiesen, dass das erzeugte Magnetfeld eine besonders hohe Homogenität besitzt, d.h. die Magnetfeldlinien weisen eine geringere seitliche Verzerrung auf als bei der bekannten Magnetfalle 30'. Auf diese Weise werden eintretende Elektronen an sämtlichen Positionen innerhalb des Rings 32 mit dem gleichen hohen Wirkungsgrad abgefangen. Besonders überraschend war jedoch die Feststellung, dass auch das jenseits des Ringelements 32 austretende magnetische Streufeld gegenüber herkömmlichen Systemen deutlich abgeschwächt ist. Mit anderen Worten wird das magnetische Streufeld effektiver in das hochpermeable Material des Ringelements 32 konzentriert als bei bekannten Magnetfallen.

Die durch die entsprechenden Pfeile angedeuteten magnetischen Orientierungen der Magnetelemente 34 sind so gewählt, dass im Zentrum der Magnetfalle 30 ein möglichst homogenes Magnetfeld entsteht, d.h. ein Magnetfeld mit möglichst gleichmäßig und parallel (in der vorliegenden Darstellung senkrecht) verlaufenden Magnetfeldlinien. Hierzu können - aus Symmetriegründen in bevorzugter Ausgestaltung der Erfindung - jeweils zwei einander gegenüberliegende Magnetelemente 34 mit gleichgerichteter Orientierung vorgesehen sein. Vorzugsweise sind mindestens zwei einander gegenüberliegende Magnetelemente (zentral orientierte Magnetelemente 34a) mit einer magnetischen Orientierung ausgestattet, die im Wesentlichen durch das Zentrum der Magnetfalle 30 gerichtet ist. Dieses zumindest eine Paar zentral orientierter Magnetelemente 34a bewirkt maßgeblich die Darstellung des zentralen, Elektronen abschirmenden Magnetfeldes. Zumindest zwei weitere einander gegenüberliegende Magnetelemente (tangential orientierte Magnetelemente 34b) hingegen weisen eine Orientierung tangential zum Zentrum der Magnetfalle 30 auf und dienen maßgebend der Homogenisierung des Magnetfeldes und weiterhin der Abschwächung des magnetischen Streufeldes außerhalb des Ringelements 32.

Bei einer möglichen - in Figur 3A angedeuteten - Ausgestaltung etwa verlaufen die nicht dargestellten zentralen Magnetfeldlinien beginnend von den beiden oberen zentral orientierten Magnetelementen 34a zu den beiden unteren zentral orientierten Magnetelementen 34a. Die beiden seitlich angeordneten, tangential orientierten Magnetelemente 34b sorgen für die Homogenisierung und Verstärkung des zentralen Magnetfeldes und für die Abschwächung des magnetischen Streufeldes.

Abweichend von dem gezeigten Beispiel können auch andere Orientierungen der Magnetelemente 34 gewählt werden, die weder zentral noch tangential orientiert sind, sondern eine Orientierung mit einem gewissen "schiefen" Winkel zum Zentrum aufweisen. Derartige Ausgestaltungen sind zwar etwas kostenaufwändiger als die in Figur 3 gezeigte, können die vorteilhaften Effekte der hohen Homogenität des Magnetfeldes sowie die Unterdrückung des äußeren Streufeldes jedoch ebenso bewirken und sind daher ebenfalls von der vorliegenden Erfindung eingeschlossen.

Eine weitere, mögliche Ausgestaltung der magnetischen Orientierung der Magnetelemente 34 ist in Figur 4 gezeigt, wo zwei zentral orientierte Magnetelemente 34a und vier tangential orientierte Magnetelemente 34b vorgesehen sind.

Obwohl vorliegend nur symmetrische Anordnungen von zwei jeweils einander gegenüberliegend angeordneten Magnetelementen 34 dargestellt sind, sind auch nicht-symmetrische Ausgestaltungen denkbar, bei denen insbesondere eine ungerade Anzahl von Magnetelementen 34 vorgesehen ist, die derart orientiert sind, dass die erfindungsgemäßen Effekte ebenfalls erzielt werden. Auch solche unsymmetrischen Ausführungen sind somit von der Erfindung eingeschlossen.

### Bezugszeichenliste

| | |
|---|---|
| 10 | Elektronenmikroskop / REM |
| 12 | Polschuh |
| 14 | Elektronenstrahl |
| 16 | Probe |
| 18 | Probenhalter |
| 20 | Probentisch |
| 22 | Röntgenstrahlung |
| 24 | Röntgendetektor |
| 26 | Detektorelement / Halbleiterkristall |
| 28 | Kühlvorrichtung / Peltierelement |
| 30 | Magnetfalle gemäß der Erfindung |
| 30' | Magnetfalle gemäß Stand der Technik |
| 32 | Ringelement |
| 34 | Magnetelement |

## Patentansprüche

1. Röntgendetektor (24) für die Elektronenstrahlmikroanalyse mit
(a) einem Detektorelement (26) und
(b) einer in Sichtachse des Detektorelements (26) angeordneten Magnetfalle (30) zum Einfangen von Elektronen, umfassend
(i) ein Ringelement (32) aus einem weichmagnetischen Material mit einem inneren und einem äußeren Umfang sowie
(ii) eine Anzahl N von Magnetelementen (34) umfassend ein permanentmagnetisches Material, die an dem inneren Umfang des Ringelements (32) angeordnet sind und deren magnetische Orientierungsrichtung so gewählt ist, dass im Zentrum der Magnetfalle (30) ein gerichtetes Magnetfeld vorliegt, wobei die Anzahl N der Magnetelemente (34) mindestens 3 beträgt,
**dadurch gekennzeichnet, dass** die Magnetelemente (34) entlang des inneren Umfangs des Ringelements (32) aneinandergrenzend angeordnet sind, so dass sie mosaikartig einen geschlossenen Ring ergeben.

2. Röntgendetektor (24)nach Anspruch 1,
**dadurch gekennzeichnet, dass**
die Anzahl N der Magnetelemente (34) entsprechend 2n + 2 gewählt ist und n eine natürliche Zahl ist, wobei die Anzahl N insbesondere 4, 6 oder 8 beträgt, vorzugsweise 6.

3. Röntgendetektor (24)nach einem der vorhergehenden Ansprüche,
**dadurch gekennzeichnet, dass**
die Magnetelemente (34) einen in der Ebene der Magnetfalle (30) liegenden Querschnitt in Form eines Quadrats, eines Rechtecks, eines Ringsegments oder eines Ringabschnitts aufweisen.

4. Röntgendetektor (24)nach einem der vorhergehenden Ansprüche,
**dadurch gekennzeichnet, dass**
das permanentmagnetische Material der Magnetelemente (34) ein magnetisches Energieprodukt von mindestens 50 kJ/m³, insbesondere von mindestens 100 kJ/m³, vorzugsweise von mindestens 200 kJ/m³, besitzt.

5. Röntgendetektor (24)nach einem der vorhergehenden Ansprüche,
**dadurch gekennzeichnet, dass**
das permanentmagnetische Material der Magnetelemente (34) ausgewählt ist aus der Gruppe, umfassend Neodym-Eisen-Bor- und Cobalt-Samarium-Verbindungen sowie Verbundmaterialien, welche Partikel dieser Materialien in eingebetteter Form aufweisen.

6. Röntgendetektor (24)nach einem der vorhergehenden Ansprüche,
**dadurch gekennzeichnet, dass**
das weichmagnetische Material des Ringelementes (32) eine relative magnetische Permeabilität µᵣ von mindestens 1000, insbesondere von mindestens 10000 besitzt.

7. Röntgendetektor (24) nach einem der vorhergehenden Ansprüche,
**dadurch gekennzeichnet, dass**
der Röntgendetektor (24) ein EDX-Röntgendetektor ist.

8. Röntgendetektor (24) nach einem der vorhergehenden Ansprüche,
**dadurch gekennzeichnet, dass**
das Detektorelement (26) ein Si(Li)-Detektor, ein HPGe-Detektor, eine PIN-Diode, ein aus Verbindungshalbleitern bestehender Detektor, ein SDD mit externen Transistoren oder ein Silizium-Driftdetektor mit integriertem FET (I-FET SDD) ist.

9. Röntgendetektor (24) nach einem der vorhergehenden Ansprüche, ferner umfassend eine Kühlvorrichtung (28), die insbesondere ein Peltierelement ist.

## Claims

1. An X-ray detector (24) for electron beam microanalysis, including
(a) a detector element (26) and
(b) a magnetic trap (30) that is arranged in an axis of view of the detector element (26) and serves to trap electrons, comprising
(i) an annular element (32) that is made of a soft-magnetic material and has an inner and an outer circumference and
(ii) a number N of magnetic elements (34) comprising a permanent-magnetic material, which are arranged on the inner circumference of the annular element (32) and whose direction of magnetic orientation is selected such that a directed magnetic field is provided in the centre of the magnetic trap (30), wherein the number N of magnetic elements (34) is at least 3,
**characterized in that** the magnetic elements (34) are arranged adjoining each other along the inner circumference of the annular element (32), so that they form a closed ring in a mosaic-like fashion.

2. The X-ray detector (24) according to claim 1,
**characterized in that**
the number N of magnetic elements (34) is selected according to 2n + 2 and n is a natural number, wherein the number N is in particular 4, 6 or 8, preferably 6.

3. The X-ray detector (24) according to any one of the preceding claims,
**characterized in that**
the magnetic elements (34) have a cross section that is located in the plane of the magnetic trap (30) and that is shaped like a square, a rectangle, a ring segment or a ring portion.

4. The X-ray detector (24) according to any one of the preceding claims,
**characterized in that**
the permanent-magnetic material of the magnetic elements (34) has a magnetic energy product of at least 50 kJ/m³, in particular at least 100 kJ/m³, preferably at least 200 kJ/m³.

5. The X-ray detector (24) according to any one of the preceding claims,
**characterized in that**
the permanent-magnetic material of the magnetic elements (34) is selected from the group comprising neodymium-iron-boron and cobalt-samarium compounds as well as composite materials comprising embedded particles of said materials.

6. The X-ray detector (24) according to any one of the preceding claims,
**characterized in that**
the soft-magnetic material of the annular element (32) has a relative magnetic permeability µᵣ of at least 1000, in particular at least 10000.

7. The X-ray detector (24) according to any one of the preceding claims,
**characterized in that**
the X-ray detector (24) is an EDX X-ray detector.

8. The X-ray detector (24) according to any one of the preceding claims,
**characterized in that**
the detector element (26) is an Si(Li) detector, an HPGe detector, a PIN diode, a detector consisting of compound semiconductors, an SDD with external transistors or a silicon drift detector with integrated FET (I-FET SDD).

9. The X-ray detector (24) according to any one of the preceding claims, further comprising a cooling device (28), which is in particular a Peltier element.

## Revendications

1. Détecteur de rayons X (24) pour la microanalyse des rayons électroniques, avec
(a) un élément de détecteur (26) et
(b) un piège magnétique (30) disposé dans l'axe visuel de l'élément de détecteur (26) pour piéger des électrons, comprenant
(i) un élément annulaire (32) réalisé dans une matériau magnétique doux avec une circonférence intérieure et une circonférence extérieure, ainsi que
(ii) un nombre d'éléments magnétiques (34) comprenant un matériau magnétique permanent et qui sont disposés sur la circonférence intérieure de l'élément annulaire (32) et dont la direction d'orientation magnétique est choisie de telle sorte que, au centre du piège magnétique (30), il existe un champ magnétique dirigé, le nombre N d'éléments magnétiques (34) étant au moins égal à 3,
**caractérisé en ce que** les éléments magnétiques (34) sont disposés de façon juxtaposée le long de la circonférence intérieure de l'élément annulaire (32) de sorte qu'ils constituent une bague fermée à la façon d'une mozaïque.

2. Détecteur de rayons X (24) selon la revendication 1,
**caractérisé en ce que**
le nombre N d'éléments magnétiques (34) est choisi selon 2n + 2, et **en ce que** n est un nombre naturel, le nombre N étant en particulier égal à 4, 6 ou 8, de préférence égal à 6.

3. Détecteur de rayons X (24) selon une des revendications précédentes,
**caractérisé en ce que**
les éléments magnétiques (34) présentent une section transversale, située dans le plan du piège magnétique (30), sous forme d'un carré, d'un rectangle, d'un segment annulaire ou d'un tronçon annulaire.

4. Détecteur de rayons X (24) selon une des revendications précédentes,
**caractérisé en ce que**
le matériau magnétique permanent des éléments magnétiques (34) possède un produit énergétique magnétique d'au moins 50 kJ/m³, en particulier d'au moins 100 kJ/m³, de préférence d'au moins 200 kJ/m³.

5. Détecteur de rayons X (24) selon une des revendications précédentes,
**caractérisé en ce que**
le matériau magnétique permanent des éléments magnétiques (34) est sélectionné parmi le groupe comprenant des composés néodyme-fer-bore et cobalt-samarium ainsi que des matériaux composites qui présentent des particules de ces matériaux sous forme enrobée.

6. Détecteur de rayons X (24) selon une des revendications précédentes,
**caractérisé en ce que**
le matériau magnétique doux de l'élément annulaire (32) possède une perméabilité magnétique relative µᵣ d'au moins 1 000, en particulier d'au moins 10 000.

7. Détecteur de rayons X (24) selon une des revendications précédentes,
**caractérisé en ce que**
le détecteur de rayons X (24) est un détecteur de rayons X à dispersion d'énergie.

8. Détecteur de rayons X (24) selon une des revendications précédentes,
**caractérisé en ce que**
l'élément de détecteur (26) est un détecteur Si(Li), un détecteur HPGe, une diode PIN, un détecteur constitué de composés semi-conducteurs, un SSD avec des transistors externes ou un détecteur au silicium à diffusion avec FET intégré (I-FET SDD).

9. Détecteur de rayons X (24) selon une des revendications précédentes, comprenant également un dispositif de refroidissement (28) qui est en particulier un élément Peltier.
